# FASCICULE DE BREVET EUROPEEN

(11) **EP 3 231 006 B1**
(45) Date de publication et mention de la délivrance du brevet: **05.10.2022**
(21) Numéro de dépôt: 15821112.8
(22) Date de dépôt: 11.12.2015
(51) Int. Cl.: H01L 21/02, C30B 25/18, C30B 29/40

(54) **PROCEDE DE FABRICATION DE PLAQUETTES DE NITRURE D'ELEMENT 13 A ANGLE DE TRONCATURE NON NUL**
VERFAHREN ZUR HERSTELLUNG VON WAFERN EINES NITRIDS EINES ELEMENTS 13 MIT TRUNKIERUNGSWINKEL UNGLEICH NULL
METHOD FOR THE PRODUCTION OF WAFERS OF NITRIDE OF ELEMENT 13, HAVING A NON-ZERO TRUNCATION ANGLE

(30) Priorité: 11.12.2014 FR 1462283
(43) Date de publication de la demande: 18.10.2017
(73) Titulaire: IV Works Co., Ltd, Daejeon, 34122 (KR)
(72) Inventeur: BEAUMONT, Bernard, 06530 Le Tignet (FR); LE ROUX, Vianney, 06600 Antibes (FR); COLE, Jason, Webster, Massachusetts 01570 (US)
(74) Mandataire: Regimbeau
(86) Numéro de dépôt international: PCT/FR2015/053434
(87) Numéro de publication internationale: WO 2016/092226

(56) Documents cités:
- US-A1- 2005 208 687
- US-A1- 2005 217 565
- US-A1- 2007 072 396
- US-A1- 2011 006 397
- US-A1- 2012 184 090
- FARRELL R M ET AL: "Effect of carrier gas and substrate misorientation on the structural and optical properties of m-plane InGaN/GaN light-emitting diodes", JOURNAL OF CRYSTAL GROWTH, ELSEVIER, AMSTERDAM, NL, vol. 313, no. 1, 15 décembre 2010 (2010-12-15), pages 1-7, XP027504741, ISSN: 0022-0248, DOI: 10.1016/J.JCRYSGRO.2010.08.060 [extrait le 2010-10-01]

## Description

### DOMAINE TECHNIQUE

L'invention concerne le domaine technique général de la fabrication de matériau semi-conducteur à base d'éléments des colonnes 13 et 15 du tableau périodique - tels que du nitrure de gallium GaN.

Notamment, la présente invention concerne un procédé de fabrication de plaquettes (ou « *wafer »* selon la terminologie anglo-saxonne) de nitrure d'élément 13 présentant un angle de troncature (ou « *offcut angle* ») non nul.

Dans le cadre de la présente invention, l'angle de troncature en un point de la surface d'une plaquette est défini par l'angle entre :
- la normale à une face avant de la plaquette de nitrure d'élément 13 (normale au point pour lequel l'angle de troncature est défini) et
- la normale (également connue sous le nom d'axe C) à un plan cristallin d'orientation C (0001) (normale au plan cristallin au point précité).

Une telle plaquette de nitrure d'élément 13 peut être destinée à la réalisation de structures semi-conductrices telles que des diodes électroluminescentes (DEL) ou des diodes laser (DL).

### PRESENTATION DE L'ART ANTERIEUR

Les procédés actuels de fabrication de matériaux semi-conducteurs à base de nitrure d'élément 13 reposent sur la technique dite d'hétéro-épitaxie qui consiste à faire croître un cristal (tel qu'un cristal de nitrure de gallium GaN) sur un substrat de départ de nature différente (tel qu'un substrat de saphir).

Toutefois, la technique d'hétéro-épitaxie induit de nombreux défauts cristallins dans la structure de nitrure d'élément 13, tels que des dislocations, limitant les performances et la durée de vie des composants à base de nitrure d'élément 13.

Ces défauts sont dus aux différences de matériau entre le substrat de départ et la couche de nitrure d'élément 13, et notamment au désaccord :
- de paramètres de réseau cristallin (i.e. paramètre de maille) entre le substrat de départ et la couche de nitrure d'élément 13, et
- de coefficient de dilatation thermique entre le substrat de départ et la couche de nitrure d'élément 13.

Généralement, les procédés de fabrication connus permettent d'obtenir des couches de nitrure d'élément 13 d'orientation C (0001) à partir de substrats de départ de saphir Al₂O₃ d'orientation C (0001).

Les couches de nitrure d'élément 13 ainsi fabriquées présentent un angle de troncature nul. De telles couches de nitrure d'élément 13 sont de très bonne qualité puisque certaines présentent un nombre limité de défauts cristallins (densité de dislocation TDD < 5.10⁸ cm⁻², où « *TDD* » est le sigle de l'expression anglo-saxonne *« Threading Dislocation Density »).*

Les composants optoélectroniques réalisés sur des couches de nitrure d'élément 13 d'angle de troncature nul présentent certaines propriétés défavorables telles que une rugosité de surface importante des couches épitaxiées, ou encore une plus faible capacité à incorporer des éléments comme l'Indium par exemple.

D'autres procédés de fabrication connus permettent d'obtenir des cristaux de nitrure d'élément 13 présentant un angle de troncature non nul, afin de réaliser des composants optoélectroniques ne présentant pas les inconvénients cités précédemment.

Le document JP 56059699 décrit ainsi la possibilité de fabriquer un cristal de nitrure d'élément 13 dont l'angle de troncature est compris entre 0,5 et 4 degrés, ledit cristal étant obtenu par épitaxie sur un substrat de saphir présentant un angle de troncature compris entre 0,5 et 4 degrés.

Toutefois, même si une croissance par épitaxie sur un substrat d'angle de troncature non nul permet d'obtenir un cristal de nitrure d'élément 13 d'angle de troncature non nul, la qualité cristalline d'un tel cristal n'est pas suffisante pour permettre la fabrication de composants optoélectroniques, notamment du fait de la présence de fautes d'empilement et des dislocations.

L'article « Effect of Slight Misorientation of Sapphire Substrate on Metalorganic Chemical Vapor Deposition Growth of GaN » de « Takayuki YUASA and all » du « Journal of Applied Physics vol 38 (1999) page L703-705 Part 2 n°7A, 1 July 1999 *»* montre l'intérêt d'utiliser un substrat de saphir présentant un angle de troncature de l'ordre de 0,1 à 0,2 degrés pour réaliser un cristal de GaN de morphologie uniforme, l'utilisation d'un substrat de départ présentant un angle de troncature trop élevé induisant l'obtention d'un cristal de GaN présentant une face de croissance en écaille (ou de type « *scale shaped »* selon la terminologie anglo-saxonne). Toutefois pour certaines applications, des angles de troncature aussi petit et dans une gamme aussi restreintes peuvent être insuffisants.

Pour des angles de troncature plus importants, le document US 2012/0184090 propose une méthode dans laquelle des plaquettes de nitrure d'élément 13 ayant un angle de troncature non nul sont obtenues par découpe d'un lingot épais de nitrure d'élément 13 d'angle de troncature nul.

Plus précisément, la méthode décrite dans US 2012/0184090 consiste à :
- faire croître un lingot nitrure d'élément 13 d'angle de troncature nul, et à
- réaliser une découpe du lingot selon des plans de coupe inclinés parallèles au plan de cristallisation en périphérie dudit lingot.

Ceci permet d'obtenir des plaquettes de nitrure d'élément 13 ayant un angle de troncature non nul dans la région centrale de la plaquette, l'angle de troncature diminuant dans une région périphérique de la plaquette.

De telles plaquettes de nitrure d'élément 13 ayant un angle de troncature non nul sont de qualité cristalline équivalente à celle des couches de nitrure d'élément 13 à angle de troncature nul.

Toutefois, la découpe d'un lingot épais selon un plan de coupe incliné induit des pertes importantes de matières.

On connait également d'après le document US2011/0006397 un procédé de fabrication de lingots dont l'angle de troncature est non nul au centre mais qui ne décrit pas la fabrication de plaquettes.

Un but de la présente invention est de proposer un procédé de fabrication de plaquettes de nitrure d'élément 13 d'angle de troncature non nul ayant une qualité sensiblement équivalente voire supérieure à celle des couches de nitrure d'élément 13 d'angle de troncature nul, ledit procédé permettant de limiter les pertes de matière, et pouvant être mis en œuvre avec tout type de substrat de départ quel que soit son angle de troncature, et notamment avec des substrats de départ présentant des angles de troncature importants pouvant atteindre 5 degrés.

### RESUME DE L'INVENTION

A cet effet, l'invention propose un procédé de fabrication de plaquettes de nitrure d'élément 13 chaque plaquette comprenant une face avant et un axe principal orthogonal à sa face avant et passant par le centre de cette face avant, cette face avant ayant un angle de troncature non nul au voisinage de son centre et des valeurs d'angle de troncature distribuées de manière symétrique autour de son axe principal dans un plan de symétrie contenant ledit axe principal de la plaquette et un axe C qui est orthogonal à un plan cristallin d'orientation C et ces valeurs d'angles de troncature diminuant vers la périphérie de la plaquette, le long dudit plan de symétrie lorsque la surface opposée à sa face avant est concave, et augmentant vers la périphérie de la plaquette, le long dudit plan de symétrie lorsque la surface opposée à sa face avant est convexe.
Conformément à l'invention, ce procédé comprend :
- une phase de croissance épitaxiale d'une première couche de nitrure d'élément 13 sur un substrat de départ présentant un angle de troncature compris entre 0,1 et 5 degrés, préférentiellement compris entre 0,2 et 0,8 degrés, et encore plus préférentiellement compris entre 0,3 et 0,6 degrés; ;
- une phase de formation d'une zone de séparation ;
- une phase de reprise d'épitaxie, pour former une deuxième couche de nitrure d'élément 13 sur ladite première couche de nitrure d'élément 13, cette phase de reprise d'épitaxie étant effectuée à l'issue de la phase de croissance épitaxiale et de la phase de formation de la zone de séparation,
- une phase de séparation spontanée, au niveau de la zone de séparation, durant la phase de reprise d'épitaxie, pour obtenir un cristal autosupporté bombé de nitrure d'élément 13 s'étendant longitudinalement le long d'un axe principal orthogonal à une face de croissance dudit cristal et passant par le centre de ladite face de croissance, ledit cristal autosupporté bombé présentant un angle de troncature de valeur non nulle et un rayon de courbure inférieur à 25 mètres,
- une phase de découpe dudit cristal autosupporté bombé, selon des plans de coupe transversaux au cristal et perpendiculaires à l'axe principal du cristal, de sorte à obtenir lesdites plaquettes de nitrure d'élément 13, la phase de formation de la zone de séparation étant mise en œuvre avant, après ou pendant la phase de croissance épitaxiale.

On obtient ainsi des plaquettes dont la plus grande dimension de sa face avant (le diamètre dans le cas d'une plaquette circulaire) peut varier typiquement entre 30 millimètres et 200 millimètres en fonction de la taille du substrat de départ utilisé (dont la plus grande dimension peut être comprise entre 30-200mm).

On entend dans le cadre de la présente invention, par « *voisinage du centre d'une face* », une région de la face s'étendant dans un rayon de 10 millimètres autour du centre de ladite face.

Contrairement au lingot décrit dans le document US 2012/0184090, le cristal selon l'invention à partir duquel des plaquettes sont découpées présente avantageusement un angle de troncature différent de zéro sur sa face de croissance.

Les inventeurs ont donc développé une méthode d'usinage adaptée à cette configuration du cristal. En particulier, les inventeurs proposent de découper le cristal selon des plans de coupe P transversaux au cristal, en particulier orthogonaux à un axe principal A du cristal. Ceci permet d'obtenir un rendement de matière bien meilleur que celui décrit dans le document US 2012/0184090.

Des aspects préférés mais non limitatifs du procédé décrit ci-dessus sont décrits dans les parties suivantes.

Le cristal autosupporté bombé présente un rayon de courbure inférieur à 20 mètres.

Le rayon de courbure est de 5 mètres ou plus.

Le cristal autosupporté bombé a une densité de dislocation de 10⁷cm⁻² ou inférieure.

L'angle de troncature (de chaque plaquette après la mise en œuvre de la phase de découpe) non nul au voisinage du centre de la face avant est compris entre 0,1 et 5 degrés, préférentiellement compris entre 0,2 et 0,8 degrés, encore plus préférentiellement compris entre 0,3 et 0,6 degrés, les plans de coupe s'étendant perpendiculairement à l'axe principal A du cristal.

Le fait de découper le cristal selon des plans de coupe orthogonaux à l'axe principal permet d'obtenir des plaquettes dont les angles de troncature sont répartis de manière symétrique autour de l'axe principal ; ceci facilite la fabrication ultérieure de composants optoélectronique.

De préférence, les plans de coupe s'étendent :
- perpendiculairement à l'axe principal du cristal, et
- parallèlement les uns aux autres le long dudit axe principal,
de sorte à obtenir des plaquettes de nitrure d'élément 13 d'épaisseur comprise entre 300 micromètres et 1 millimètre.

Le fait de découper le cristal selon des plans de coupe parallèles entre eux permet d'obtenir une pluralité de plaquettes dans lesquelles les plans cristallins sont répartis de manière homogène d'une plaquette à l'autre ; ceci permet en outre de maximiser le nombre de plaquettes découpées dans un cristal.
- Le substrat de départ présente un plan de cristallisation compris entre 0,1 et 5 degrés, préférentiellement compris entre 0,2 et 0,8 degrés, et encore plus préférentiellement compris entre 0,3 et 0,6 degrés.

La mise en œuvre des phases de croissance d'une couche de nitrure d'élément 13, de formation d'une zone de séparation, de reprise de croissance et de séparation permet d'obtenir un cristal de haute qualité et de rayon de courbure particulièrement faible (cristal bombé), ce qui rend la phase de découpe selon l'invention particulièrement fiable et rapide.

Selon une variante de réalisation, la phase de formation d'une zone de séparation comprend le dépôt d'une couche de silicium sur le substrat de départ, ladite couche de silicium étant destinée à être vaporisée spontanément durant la phase de reprise d'épitaxie.

Selon une autre variante de réalisation, la phase de formation d'une zone de séparation comprend une étape d"implantation d'ions, ladite étape d'implantation étant mise en œuvre pendant ou après la phase de croissance épitaxiale de la première couche de nitrure d'élément 13.

La mise en œuvre d'une étape d'implantation permet de créer une zone fragilisée à l'interface entre le substrat de départ et la première couche de nitrure d'élément 13.

Dans un mode de réalisation, la phase de croissance épitaxiale de la première couche de nitrure d'élément 13 est une phase de surcroissance latérale épitaxiale (ELO) ou universelle (ULO) de la première couche de nitrure d'élément 13.

La mise en œuvre d'une phase de surcroissance latérale (ELO ou ULO) pour former la première couche de nitrure d'élément 13 permet d'améliorer la qualité de la première couche de nitrure d'élément 13 épitaxiée, notamment en courbant les dislocations lors de l'étape de croissance latérale.

Optionnellement, la phase de croissance épitaxiale de la première couche de nitrure d'élément 13 comprend :
- une étape de dépôt d'un masque incluant des ouvertures,
- une étape de croissance d'ilots de nitrure d'élément 13 à travers les ouvertures, les ilots présentant un plan de cristallisation compris entre 0,1 et 5 degrés, préférentiellement compris entre 0,2 et 0,8 degrés, et encore plus préférentiellement compris entre 0,3 et 0,6 degrés,
- une étape de croissance latérale pour favoriser la coalescence des îlots afin d'obtenir la première couche de nitrure d'élément 13.

Le fait de déposer un masque lors de la phase de surcroissance ELO permet de fragiliser l'interface entre le substrat de départ et la première couche de nitrure d'élément 13.

Selon un autre aspect de la présente invention, la phase de croissance épitaxiale de la première couche de nitrure d'élément 13 comprend une étape de dépôt d'une couche tampon de nitrure d'élément 13 entre le substrat de départ et ladite première couche de nitrure d'élément 13, à une température comprise entre 500 et 700°C, la couche tampon étant choisie parmi l'AIN ou l'AlGaN.

La couche tampon assure une transition « *douce* » entre le substrat de départ et la première couche de nitrure d'élément 13. Le dépôt de la couche tampon à basse température (i.e. température comprise entre 500 et 700°C) permet d'améliorer la qualité de la couche de nitrure d'élément 13 en filtrant les défauts cristallins liés au désaccord de paramètre de maille entre le substrat de départ et la couche de nitrure d'élément 13.

Préférentiellement, la phase de croissance épitaxiale de la première couche de nitrure d'élément 13 comprend une étape de recuit de la couche tampon à une température comprise entre 900 et 1150°C de sorte à convertir la couche tampon initialement continue en une couche discontinue de motifs de nitrure d'élément 13.

L'étape de recuit permet de faciliter la séparation de la première couche de nitrure d'élément 13 en convertissant la couche tampon initialement continue en une couche discontinue de motifs de nitrure d'élément 13.

La plaquette de nitrure d'élément 13 telle que décrite ci-dessus peut être utilisée pour la fabrication de composants optoélectroniques.

### BREVE DESCRIPTION DES DESSINS

D'autres avantages et caractéristiques du procédé selon l'invention et du produit associé ressortiront mieux de la description qui va suivre de plusieurs variantes d'exécution, données à titre d'exemples non limitatifs, à partir des dessins annexés sur lesquels :
- La figure 1 illustre un exemple de procédé de fabrication selon l'invention,
- La figure 2 illustre schématiquement un matériau semi-conducteur composé d'un empilement de couches,
- La figure 3 illustre une face de croissance d'un cristal (ou lingot) de nitrure d'élément 13 autosupporté,
- La figure 4 illustre un exemple de cristal de nitrure d'élément 13,
- La figure 5 illustre un exemple de plaquettes de nitrure d'élément 13 obtenues en découpant le cristal illustré à la figure 4 ;
- La figure 6 est une autre représentation illustrant différents paramètres intervenant dans un mode de mise en œuvre dans le cas d'une plaquette concave ;
- La figure 7 illustre le cas d'une plaquette convexe.

### DESCRIPTION DETAILLEE DE L'INVENTION

On va maintenant décrire plus en détails différents exemples de procédés de fabrication de plaquettes de matériau semi-conducteur, ainsi que de plaquettes ainsi obtenues en référence aux figures.

Dans ces différentes figures, les éléments équivalents portent les mêmes références numériques. Dans la suite, on décrira le procédé selon l'invention en référence à la fabrication de plaquettes de nitrure de gallium GaN.

Toutefois, il est bien évident pour l'homme du métier que le procédé décrit ci-dessous peut être utilisé pour faire croître un matériau incluant une couche de nitrure d'élément 13 autre que du nitrure de gallium GaN.

### 1. Procédé de fabrication

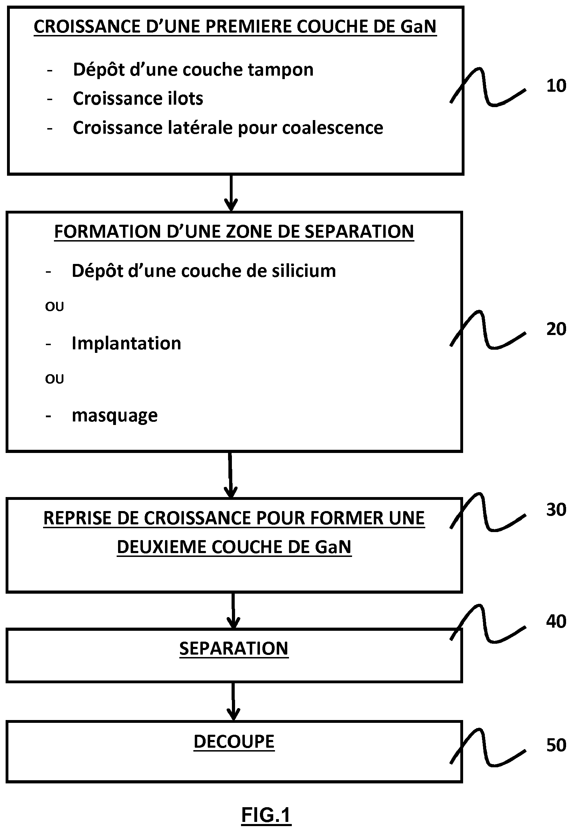

En référence à la figure 1, on a illustré les grandes phases du procédé de fabrication de plaquettes de GaN.

Le procédé comprend :
i) une phase 10 de croissance d'une première couche de GaN 5',
ii) une phase 20 de formation d'une zone de séparation 4,
iii) une phase 30 de reprise d'épitaxie pour former une deuxième couche épaisse de GaN 5",
iv) une phase 40 de séparation pour obtenir un cristal de GaN 5,
v) une phase 50 de découpe du cristal de GaN 5 pour former des plaquettes de GaN 5a-5d.

### 1.1. Phase 10 de croissance

La phase de croissance 10 consiste à former une première couche de GaN 5' par surcroissance latérale.

La surcroissance latérale permet de minimiser la densité de défauts contenus dans la première couche de GaN 5'.

L'approche utilisée pour réduire la densité de dislocations dans la première couche de GaN 5' consiste à :
- initier un mode de croissance du GaN par îlots, puis à
- favoriser la coalescence des îlots pour obtenir la première couche de GaN 5'.

La surcroissance latérale est mise en œuvre sur un substrat de départ 1 présentant un angle de troncature non nul.

Le fait d'utiliser un substrat de départ 1 présentant un angle de troncature non nul permet de faire croître une première couche de GaN 5' ayant un angle de troncature non nul.

Le substrat de départ 1 peut être choisi parmi Si, AIN, GaN, GaAs, Al2O3 (saphir), ZnO, SiC, LiAlO2, LiGaO2, MgAl2O4, 4H-SiC, ou tout autre type de substrat de départ connu par l'homme du métier pour mettre en œuvre une croissance de nitrure de gallium. Il peut présenter une épaisseur de quelques centaines de micromètres, généralement 350 micromètres. Avantageusement, le substrat de départ 1 peut être traité par nitruration préalablement à toute étape de dépôt. Ceci permet d'améliorer la qualité du cristal de GaN obtenu à l'issue de l'étape iv).

L'angle de troncature est compris entre 0,1 et 5 degrés, préférentiellement entre 0,2 et 0,8 degrés, et encore plus préférentiellement entre 0,3 et 0,6 degrés (notamment pour limiter les fautes d'empilement).

La croissance de la première couche de GaN 5' peut être mise en œuvre selon différentes variantes. Notamment, la surcroissance latérale peut être basée :
- sur l'utilisation d'un masque diélectrique 3a, 3b incluant des ouvertures 3a dans lesquelles se forment les îlots, tel que décrit dans le document WO99/20816 ;
- sur l'utilisation d'une couche de diélectrique dépourvue d'ouverture sur laquelle se forment spontanément des îlots, tel que décrit dans le document EP 1 338 683.

### 1.1.1. Première variante de surcroissance latérale

Dans une première variante,la phase 10 de croissance consiste en une surcroissance latérale épitaxiale (ci-après dénommée « *ELO* » selon l'acronyme de l'expression anglo-saxonne « *Epitaxial Lateral Overgrowth »*).

L'ELO comprend une étape de dépôt d'une couche tampon 2 sur le substrat de départ 1.

Ce dépôt est de préférence réalisé par épitaxie phase vapeur aux organométalliques (ou « *MOVPE* », sigle de l'expression anglo-saxonne *« MetalOrganic Vapour Phase Epitaxy* »), par exemple à une température comprise entre 500°C et 700°C, notamment de 600°C.

Le dépôt d'une couche tampon 2 permet de réduire les contraintes entre le substrat de départ 1 et la première couche de GaN 5' épitaxiée par la suite sur celui-ci. En effet, le dépôt de la couche tampon 2 sur le substrat 1 permet d'assurer une transition « *douce »* entre le substrat 1 et la première couche de GaN 5' dont les structures cristallines sont différentes.

Le dépôt de la couche tampon 2 permet en outre de faciliter la séparation ultérieure du cristal de GaN 5, comme il ressortira de la description qui va suivre. La couche tampon 2 est par exemple une couche de GaN, une couche d'AIN, ou une couche d'AlGaN.

Dans une autre étape, un masque 3a, 3b incluant des ouvertures 3a est formé. Les ouvertures 3a peuvent être ponctuelles ou sous forme de bandes et permettent de définir des positions pour la croissance sélective ultérieure d'ilots de GaN.

Le masque 3a, 3b peut être un masque en matériau diélectrique, comme par exemple du SiNx (SiN, Si₃N₄, etc.) ou du SiO₂ ou du TiN. Ceci permet de minimiser les défauts créés en bord de masque et améliore ainsi la qualité de la couche de GaNépitaxiée ultérieurement sur celui-ci.

La formation du masque 3a, 3b peut être réalisée par toute technique connue de l'homme du métier. Par exemple, la formation du masque peut consister en :
- le dépôt d'une couche de diélectrique 3a à partir de précurseurs gazeux de silane et d'ammoniac directement sur la couche tampon 2, et
- la gravure par photolithographie de la couche de diélectrique 3a pour former des ouvertures 3a.

On obtient ainsi un substrat de départ 1 recouvert d'une couche tampon 2 et d'un masque 3a, 3b. Outre sa fonction d'amélioration de la qualité de la première couche de GaN 5' (par filtration des défauts traversants), le masque 3a, 3b permet de fragiliser l'interface entre le substrat de départ 1 et la première couche de GaN 5'.

Une autre étape consiste à former des ilots de GaN à travers les ouvertures 3a du masque. La vitesse de croissance selon un axe orthogonal au plan principal du substrat de départ 1 est maintenue supérieure à la vitesse de croissance latérale. On obtient ainsi des ilots ou des bandes à sections triangulaires (en fonction de la forme des ouvertures 3a). A l'intérieur de ces bandes à section triangulaire, les dislocations traversantes sont courbées à 90°.

On procède ensuite à une surcroissance latérale pour aboutir au final à une couche plane ELO. On obtient à la fin de cette étape du procédé une première couche de GaN 5' présentant une densité de dislocations inférieure à 10⁷cm⁻².

### 1.1.2. Deuxième variante de surcroissance latérale

Dans une deuxième variante la phase 10 de croissance consiste en une surcroissance latérale universelle (ci-après dénommée « *ULO* » selon l'acronyme de l'expression anglo-saxonne « *Universal Lateral Overgrowth* ») tel que décrit dans le document EP 1 977 028.

L'ULO comprend une étape de dépôt d'une couche de nucléation sur le substrat de départ 1.

La couche de nucléation est par exemple un film très mince de nitrure de silicium SiN, de l'ordre quelques plans atomiques, autrement dit de l'ordre de 10 nm à 20 nm d'épaisseur. Le dépôt de SiN à partir de silane et d'ammoniac peut durer 360 secondes.

Une couche tampon 2 continue - par exemple de GaN - est ensuite déposée sur la couche de nucléation. Le dépôt de la couche tampon 2 de GaN permet de filtrer les défauts cristallins et ainsi de minimiser dès le début du procédé la densité de défauts qui sera présente dans la première couche de GaN 5' épitaxiée par la suite.

L'épaisseur de cette couche tampon 2 de GaN peut être comprise entre 10 et 100 nm. La température lors de cette opération peut être comprise entre 500 et 700°C.

On procède ensuite à un recuit à haute température comprise entre 900 et 1150 °C. Sous l'effet conjoint de l'élévation de la température, de la présence dans le véhicule gazeux d'une quantité d'hydrogène suffisante et de la présence du film très mince de SiN, la morphologie de la couche tampon 2 de GaN subit une profonde modification résultant d'une recristallisation en phase solide par transport de masse. La couche tampon 2 de GaN initialement continue est alors convertie en une couche discontinue de motifs de GaN. On obtient ainsi des motifs ou îlots de GaN de très bonne qualité cristalline et conservant une relation d'épitaxie avec le substrat de départ grâce à la très faible épaisseur de la couche de nucléation.

Les zones où le nitrure de silicium SiN est mis à nu fonctionnent alors comme un masque et les motifs de GaN fonctionnent comme les zones de GaN localisées dans les ouvertures réalisées ex-situ dans le masque. On procède ensuite à une surcroissance latérale pour aboutir au final à une couche plane ULO.

Cette méthode, où le masque de nitrure de silicium se forme spontanément, et qui fait intervenir les mêmes mécanismes de courbure des dislocations que dans l'ELO est identifié comme « *ULO » (ou « ELO spontané »).*

### 1.2. Phase 20 de formation d'une zone de séparation 4

Le procédé comprend de plus une phase 20 de formation d'une zone de séparation 4.

Cette phase 20 de formation d'une zone de séparation peut être mise en œuvre selon différentes variantes. En particulier, la phase 20 de formation de la zone de séparation peut être mise en œuvre :
- préalablement à la phase 10 de croissance de la première couche de GaN (première variante), ou
- postérieurement à la phase 10 de croissance de la première couche de GaN (deuxième variante)
- pendant la phase 10 de croissance de la première couche de GaN (troisième variante).

### 1.2.1. Première variante de formation de la zone de séparation 4

Dans une première variante, la phase 20 de formation d'une zone de séparation 4 peut consister à déposer une couche intermédiaire de silicium Si préalablement à la phase 10 de croissance de la première couche de GaN 5', tel que décrit dans le document EP 1 699 951.

La couche intermédiaire de silicium Si sert de couche sacrificielle.

### 1.2.2. Deuxième variante de formation de la zone de séparation

Dans une deuxième variante, la phase 20 de formation d'une zone de séparation 4 comprend une étape d'implantation réalisée après la phase 10 de croissance de la première couche de GaN 5'. Cette implantation permet la création d'une zone fragilisée dans la première couche de GaN 5'.

L'implantation consiste à bombarder d'ions la première couche de GaN 5' de sorte à créer dans le semi-conducteur, à une profondeur voisine de la profondeur moyenne de pénétration de ces ions, une couche de microcavités (ou bulles).

Les ions implantés peuvent être choisis parmi le Tungstène, l'Hélium, le Néon, le Krypton, le Chrome, le Molybdène, le Fer, l'Hydrogène, ou le Bore. De préférence, les ions implantés sont des ions de tungstène. Ceux-ci présentent la particularité de décomposer le GaN.

En termes de dose, lorsque les ions implantés sont des ions H+, la dose d'ions implantés peut être comprise entre 10¹⁶ et 10¹⁷ cm⁻², et la profondeur d'implantation peut varier entre 0 nm et 50 nm en partant de la surface libre - appelée face de croissance - de la première couche de GaN 5'.

L'implantation d'ions de fragilisation peut être mise en œuvre lors d'une étape unique ou lors d'étapes successives. La température peut être comprise entre 4K et 1000K lors de l'étape d'implantation.

### 1.2.3. Troisième variante de formation de la zone de séparation

Dans une troisième variante, la zone de séparation 4 peut être formée pendant la phase 10 de croissance de la première couche de GaN 5'.

Notamment lorsque la phase de croissance est réalisée selon la première variante de réalisation dite ELO (i.e. dépôt d'un masque de diélectrique 3a, 3b), la phase 20 de formation de la zone de séparation 4 peut comprendre l'implantation de la couche tampon 2 préalablement au dépôt du masque 3a, 3b.

Ceci permet de placer la zone de séparation 4 à une profondeur précisément souhaitée du fait que la première couche de GaN 5' déposée lors de l'étape de surcroissance ELO ne « gêne » pas l'implantation d'ions.

Bien entendu, l'implantation peut être effectuée à différents stades de la phase de surcroissance latérale ELO (ou ULO), soit dans les îlots, soit à un stade intermédiaire où les îlots ne sont pas entièrement coalescés, soit après coalescence totale des ilots.

### 1.3. Phase de reprise d'épitaxie

A l'issue des phases 20 de formation d'une zone de séparation 4 et de croissance 10 de la première couche de GaN 5', le procédé comprend une phase de reprise d'épitaxie pour former une deuxième couche épaisse de GaN 5".

Cette reprise par épitaxie peut être mise en œuvre :
- par Epitaxie en Phase Vapeur aux OrganoMétalliques (« *MOVPE »)*
- par Epitaxie en Phase Vapeur aux Halogénures (ou « *HVPE* », sigle de l'expression anglo-saxonne « *Hydride Vapor Phase Epitaxy »),*
- par Transport de Vapeur en Espace Clos (ou « *CSVT »* sigle de l'expression anglo-saxonne « *Close-Spaced Vapor Transport* »), ou encore
- par Epitaxie en Phase Liquide (ou « *LPE* » sigle de l'expression anglo-saxonne *« Liquide Phase Epitaxy »).*

On préfère lors de cette étape mettre en œuvre la technologie « *HVPE »* qui permet l'obtention de trois principaux effets intéressants :
- Un premier effet est que la première couche de GaN 5' est épaissie sans perdre ses qualités cristallines (on ne génère ni nouvelle dislocation, ni fissure),
- Un deuxième effet est que l'on réduit encore la densité de dislocation lors de reprise d'épitaxie en HVPE, d'un facteur au moins égal à 2,
- Un troisième effet est que la couche épaisse de GaN 5 ainsi obtenue se sépare spontanément de son substrat de départ 1 au niveau de la zone de séparation 4.

On obtient ainsi une deuxième couche de GaN 5" s'étendant sur la première couche de GaN 5'. La deuxième couche de GaN 5" présente un angle de troncature non nul de valeur constante sur sa face avant.

En effet, les première et deuxième couches de GaN 5', 5" sont formées sur un substrat présentant un angle de troncature non nul de valeur constante sur sa face de croissance. Or, cet angle de troncature non nul du substrat de départ se propage dans les première et deuxième couches lors des phases de croissance 10 et de reprise d'épitaxie 30.

C'est pourquoi la face avant de la deuxième couche de GaN 5" présente un angle de troncature non nul de valeur constante en tout point de sa face avant. Plus généralement, aux différents instants des phases de croissance 10 et de reprise d'épitaxie 30, la face avant de la couche de GaN (première 5' ou deuxième 5") présente un angle de troncature non nul de valeur constante en tout point de ladite face.

### 1.4. Phase de séparation

Une phase 40 de séparation est également mise en œuvre, celle-ci dépendant de la variante implémentée pour la phase 20 de formation de la zone de séparation 4.

Dans le cas d'une implantation d'ions, la phase 40 de séparation spontanée a lieu du fait du cycle thermique (reprise d'épitaxie à haute température et refroidissement) que subit la couche épaissie de GaN 5 qui, à cause de la différence de coefficients de dilatation thermique entre le substrat de départ 1 et la couche épaisse de GaN 5, engendre des contraintes provoquant sa séparation.

Dans le cas du dépôt d'une couche intermédiaire de silicium, cette séparation intervient durant de la reprise d'épitaxie par vaporisation spontanée de la couche intermédiaire de silicium.

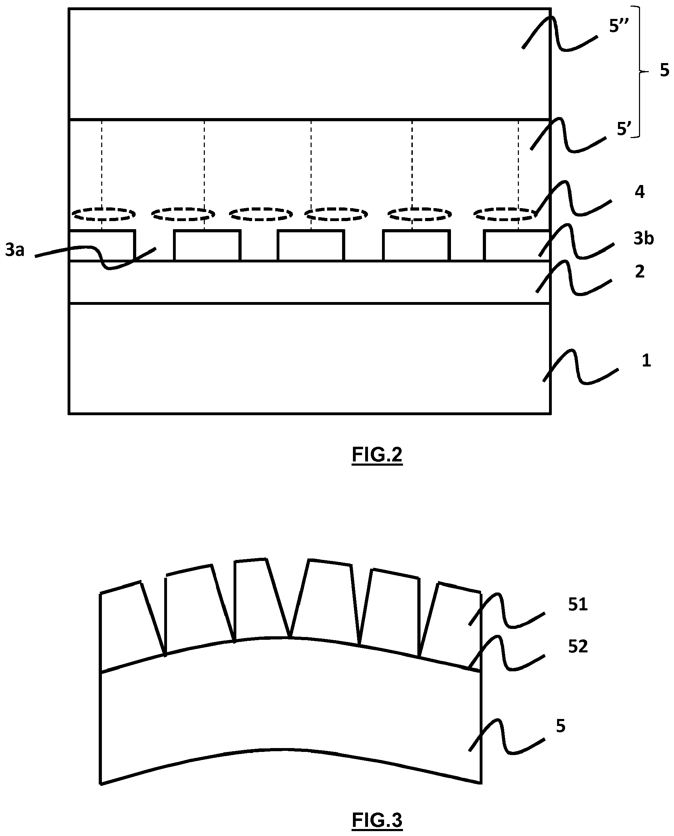

On obtient ainsi un cristal de GaN 5 autosupporté tel qu'illustré à la figure 3. Comme il est courant en HVPE, le cristal de GaN 5 comprend :
- des excroissances 51 sous forme de pyramides hexagonales sur une face avant 52, et
- des motifs géométriques correspondant à la structure ELO de départ sur une face arrière, constituée par la zone de fracture (non représentés).

Un tel cristal est bombé et présente un rayon de courbure inférieur à 25 mètres et préférentiellement inférieur à 20 mètres (rayon de courbure de la face avant 52, comme de la face du cristal opposée à ladite face avant 52 et aux excroissances 51). Dans l'exemple de la figure 3, ce rayon de courbure est de 5 mètres ou plus; par ailleurs, le cristal 5 a en outre une densité de dislocation de 10⁷cm⁻² ou inférieure.

Le cristal de GaN 5 ayant été formé sur un substrat de départ présentant un angle de troncature non nul, celui-ci présente également un angle de troncature non nul, l'orientation des plans cristallins se propageant d'une couche à l'autre. Par exemple, dans le cas d'un substrat de saphir 1 d'angle de troncature égale à 4 degrés, la face de croissance du cristal 5 présente un angle de troncature égale à 4 degrés sur toute sa surface.

### 1.5. Phase de découpe

Une fois le cristal de GaN 5 séparé du substrat de départ 1, celui-ci est découpé transversalement en plaquettes de GaN 5a, 5b, 5c, 5d.

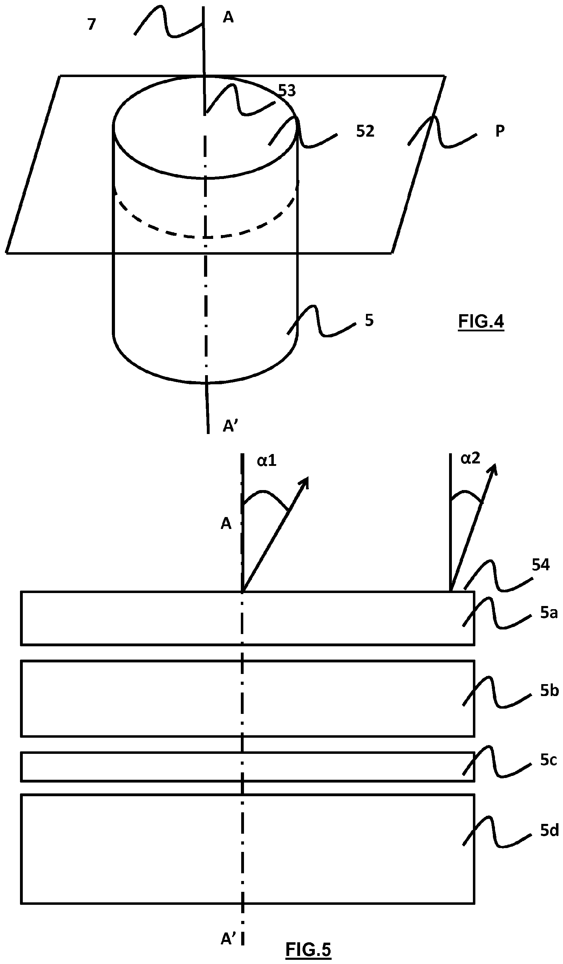

Comme illustré à la figure 4, le cristal de GAN 5 est de forme allongée et s'étend longitudinalement le long d'un axe principal A-A' (référencé 7). Cet axe principal 7 est confondu avec la normale à la face de croissance 52 du cristal 5 passant par le centre 53 de ladite face de croissance 52.

Par exemple, lorsque le cristal de GaN 5 est de forme cylindrique (ou est inscrit dans un volume cylindrique), l'axe principal 7 correspond à l'axe de révolution du cylindre.

Bien entendu, le cristal de GaN 5 peut présenter d'autres formes, la forme du cristal de GaN 5 dépendant de la forme de la face de croissance du substrat de départ 1 :
- Le cristal de GaN 5 est par exemple cylindrique lorsque la face de croissance du substrat de départ 1 est un disque,
- Le cristal de GaN 5 est parallélépipédique lorsque la face de croissance du substrat de départ 1 est carré, rectangulaire, etc.

Dans tous les cas, le cristal de GaN 5 est découpé transversalement de sorte à obtenir des plaquettes de GaN. Plus précisément, le cristal 5 est découpé selon un (ou plusieurs) plan(s) de coupe orthogonal (orthogonaux) à l'axe principal 7, de sorte à limiter les pertes de matière à l'usinage.

Ceci permet d'obtenir des plaquettes de GaN 5a, 5b, 5c, 5d ayant une densité de défaut de dislocation réduite et une durée de vie améliorée.

La phase 50 de découpe peut être effectuée en utilisant une scie à fil. Le cristal est par exemple posé sur une platine. La platine est ensuite mise en mouvement de sorte à faire tourner le cristal 5 autour de son axe principal, la scie à fil s'étendant dans un plan horizontal P perpendiculaire à l'axe principal 7 du cristal 5.

Après avoir découpé le cristal 5 selon un premier plan de coupe P, la hauteur de la scie à fil est diminuée de sorte à découper le cristal 5 selon un deuxième plan de coupe (parallèle au premier plan de coupe).

On obtient ainsi différentes plaquettes 5a, 5b, 5c, 5d, dont les épaisseurs peuvent varier en fonction de la hauteur à laquelle est positionnée la scie à fil par rapport au cristal 5.

Le cristal 5 (d'angle de troncature constant en tout point de sa face de croissance) étant « *bombé »,* et les plans de coupe étant orthogonaux à son axe principal 7, on obtient des plaquettes présentant des propriétés particulières.

Notamment, une des particularités des plaquettes 5a, 5b, 5c, 5d obtenues en mettant en œuvre le procédé décrit ci-dessus est que celles-ci comprennent un angle de troncature non nul - notamment compris entre 0,1 et 5 degrés - dans un voisinage du centre de leur face avant 54.

On entend par « *voisinage du centre d'une face* », une région de la face s'étendant dans un rayon de 10 millimètres autour du centre de ladite face.

Une autre particularité des plaquettes 5a, 5b, 5c, 5d ainsi obtenues est que, sur la face avant de chaque plaquette, les valeurs d'angle de troncature sont distribuées sensiblement symétriquement autour d'un plan de symétrie passant par l'axe principal 7 de la plaquette et l'axe C (orthogonal au plan de cristallisation C (0001)).

Avantageusement, des étapes de post-traitements peuvent être mise en œuvre sur les plaquettes 5a, 5b, 5c, 5d une fois celles-ci découpées. Notamment, chaque plaquette peut comprendre une étape de polissage mécanique ou chimique de sorte à diminuer sa rugosité de surface.

Le lecteur appréciera que l'angle de troncature de chaque plaquette, dont la valeur est non nul dans la région centrale de la plaquette varie lorsque l'on s'éloigne du centre de la plaquette le long du plan de symétrie de celle-ci.

Notamment la valeur de l'angle de troncature diminue ou augmente en fonction du caractère concave ou convexe de la plaquette.

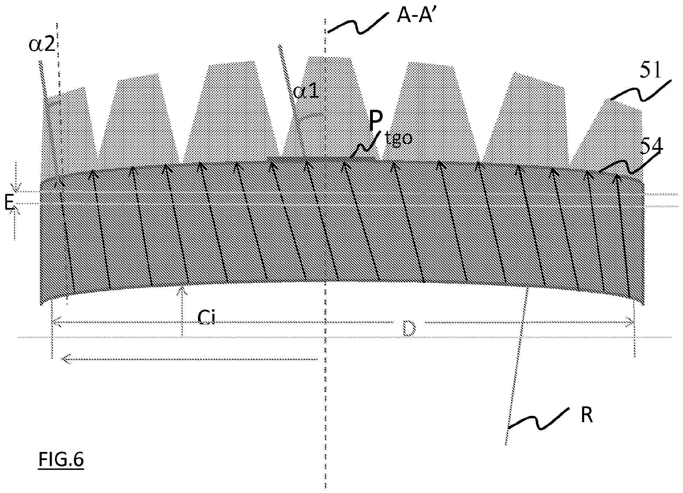

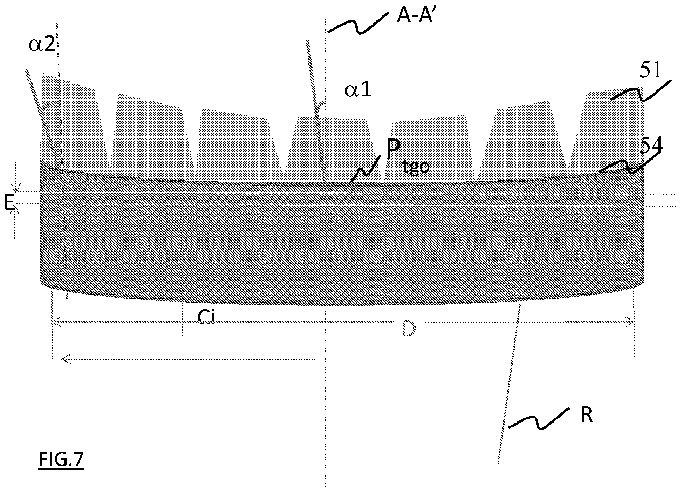

Dans tout le présent texte, une plaquette sera dite concave si sa face opposée à sa face avant est concave (c.f. figure 6) ; elle sera dite convexe lorsque cette face est elle-même convexe (c.f. figure 7).

Plus précisément, l'angle de troncature, égale à une première valeur non nulle au centre de la plaquette
- diminue vers la périphérie le long du plan de symétrie lorsque la plaquette est concave,
- augmente vers la périphérie le long du plan de symétrie lorsque la plaquette est convexe.

Ainsi pour des rayons de courbure très important (i.e. supérieur à 10 mètres) et des surfaces supérieures ou égales à quatre pouces, la courbure (concave ou convexe) de la plaquette peut varier le long d'un de ses diamètres (i.e. la plaquette peut être « gondolée »).

### 2. Expérimentations

Le procédé décrit ci-dessus permet d'obtenir une plaquette de GaN 5a, 5b, 5c, 5d ayant un angle de troncature égale à :
- une première valeur a1 non nulle au voisinage du centre de la face avant 54 de la plaquette 5a, et
- une deuxième valeur a2 à la périphérie de la face avant 54, la deuxième valeur a2 étant inférieure à la première valeur a1, comme illustré sur la figure 5.

Ainsi, le procédé selon l'invention permet d'obtenir des plaquettes de GaN du même type que les plaquettes décrites dans US 2012/0184090, mais en limitant les pertes de matière à l'usinage.

Le cristal bombé autosupporté présente une concavité telle que son rayon de courbure est inférieur à 25 mètres. Préférentiellement, le rayon de courbure est inférieur à 20 mètres. A titre d'exemple, le cristal de GaN autosupporté de la figure 3 a une concavité correspondant à un rayon de courbure de 15 mètres

Avant usinage, on réalise un profil des différentes cotes (dans la suite cotes Ci) entre la face du cristal 5 opposée à la face supérieure 52 et un plan de référence donné. Ceci permet de définir le profil exact de courbure du cristal 5. Une telle mesure est par exemple réalisée au moyen d'un palpeur micrométrique (type Starett par exemple).

Par la méthode de calcul des moindres carrés, il est possible de définir pour le cristal un plan tangent optimal Ptgo. Ce plan Ptgo est par exemple choisi tel que la somme des carrés des écarts des cotes Ci prises en utilisant ledit plan comme plan de référence soit la plus faible possible.

Après identification de l'axe A-A' (axe perpendiculaire au plan Ptgo et passant par le centre 53 de ladite face de croissance 52), la plaquette est usinée selon un plan P parallèle au plan orthogonal à cet axe A-A' selon une tranche d'épaisseur E et de diamètre D comme cela est représenté sur la figure 6. Si l'épaisseur E le permet, la tranche initiale peut être redécoupée selon le plan P en N tranches plus fines. N et D sont fonction de l'épaisseur moyenne du cristal et de son rayon de courbure.

On constate que la forme de la plaquette peut être très bien approximée par une calotte sphérique. L'axe de symétrie de la calotte a aussi par construction la même direction que l'axe principal A-A'.

Le tableau ci-dessous présente l'effet sur la perte à l'usinage d'une déviation du plan de coupe par rapport à l'axe principal du cristal.

| Déviation angulaire par rapport au plan P | Déviation linéaire | Epaisseur de cristal nécessaire pour éviter la présence de trous sur la face avant de la plaquette | Epaisseur de cristal nécessaire à l'obtention d'une plaquette de 500 µm | Augmentation relative de l'épaisseur du cristal | Temps supplémentaire nécessaire pour la croissance du cristal | Durée totale de la croissance |
|---|---|---|---|---|---|---|
| 0.00° | 0 µm | 0 µm | 2.2 mm | 0% | 0.00 h | 17.60 h |
| 0.05° | 87 µm | 262 µm | 2.5 mm | 12% | 2.09 h | 19.69 h |
| 0.10° | 175 µm | 524 µm | 2.7mm | 24% | 4.19 h | 21.79 h |
| 0.15° | 262 µm | 785 µm | 3.0 mm | 36% | 6.28 h | 23.88 h |
| 0.20° | 349 µm | 1047 µm | 3.2 mm | 48% | 8.38 h | 25.98 h |
| 0.25° | 436 µm | 1309 µm | 3.5 mm | 60% | 10.47 h | 28.07 h |
| 0.30° | 524 µm | 1571 µm | 3.8 mm | 71% | 12.57 h | 30.17 h |

Comme on peut le constater dans ce tableau, plus le plan de coupe est incliné par rapport à un plan de coupe orthogonal à l'axe principal du cristal, plus la perte de matière à l'usinage est importante.

En effet, plus le plan de coupe est incliné par rapport au plan P perpendiculaire à l'axe principal du cristal de nitrure d'élément 13, plus l'épaisseur dudit cristal doit être importante pour permettre l'obtention d'une plaquette de nitrure d'élément 13 d'angle de troncature souhaité. Outre les pertes en matière, ceci nécessite une augmentation significative du temps de croissance et donc une baisse du rendement en termes de production.

Dans la description qui précède, le procédé selon l'invention a été décrit en référence à la fabrication d'un matériau semi-conducteur incluant une couche de nitrure de gallium GaN.

Toutefois, il est bien évident pour l'homme du métier que le procédé décrit ci-dessus peut être utilisé pour faire croître un matériau incluant une couche de nitrure d'élément 13 autre que du nitrure de gallium GaN, ce matériau pouvant être utilisé pour réaliser des structures semi-conductrices telles que des diodes électroluminescentes.

## Revendications

1. Procédé de fabrication de plaquettes de nitrure d'élément 13 (5a, 5b, 5c, 5d), chaque plaquette (5a, 5b, 5c, 5d) comprenant une face avant (54) et un axe principal (7) orthogonal à sa face avant (54) et passant par le centre de cette face avant (54), cette face avant (54) ayant un angle de troncature (a1) non nul au voisinage de son centre et des valeurs d'angle de troncature distribuées de manière symétrique autour de son axe principal (7) dans un plan de symétrie contenant ledit axe principal (7) de la plaquette et un axe C qui est orthogonal à un plan cristallin d'orientation C et ces valeurs d'angles de troncature diminuant vers la périphérie de la plaquette, le long dudit plan de symétrie lorsque la surface opposée à sa face avant (54) est concave, et augmentant vers la périphérie de la plaquette, le long dudit plan de symétrie lorsque la surface opposée à sa face avant (54) est convexe, ce procédé comprenant :
- une phase de croissance épitaxiale (10) d'une première couche (5') de nitrure d'élément 13 sur un substrat de départ (1) présentant un angle de troncature compris entre 0,1 et 5 degrés, préférentiellement compris entre 0,2 et 0,8 degrés, et encore plus préférentiellement compris entre 0,3 et 0,6 degrés,
- une phase de formation (20) d'une zone de séparation (4);
- une phase de reprise d'épitaxie (30), pour former une deuxième couche (5") de nitrure d'élément 13 sur ladite première couche (5') de nitrure d'élément 13, cette phase de reprise d'épitaxie (30) étant effectuée à l'issue de la phase de croissance épitaxiale (10) et de la phase de formation (20) de la zone de séparation (4),
- une phase (40) de séparation spontanée, au niveau de la zone de séparation (4), durant la phase (30) de reprise d'épitaxie, pour obtenir un cristal autosupporté (5) bombé de nitrure d'élément 13 s'étendant longitudinalement le long d'un axe principal (7) orthogonal à une face de croissance (52) dudit cristal (5) et passant par le centre (53) de ladite face de croissance, ledit cristal autosupporté (5) bombé présentant un angle de troncature de valeur non nulle et un rayon de courbure inférieur à 25 mètres,
- une phase de découpe (50) dudit cristal autosupporté bombé (5), selon des plans de coupe (P) transversaux au cristal et perpendiculaires à l'axe principal (7 - A-A') du cristal (5), de sorte à obtenir lesdites plaquettes (5a, 5b, 5c, 5d) de nitrure d'élément 13, la phase de formation (20) de la zone de séparation (4) étant mise en œuvre avant, après ou pendant la phase de croissance épitaxiale (10).

2. Procédé de fabrication selon la revendication 1, dans lequel le cristal autosupporté (5) bombé présente un rayon de courbure inférieur à 20 mètres

3. Procédé de fabrication selon l'une des revendications 1 ou 2 dans lequel le rayon de courbure est de 5 mètres ou plus.

4. Procédé de fabrication selon l'une des revendications précédentes, dans lequel le cristal autosupporté bombé (5) a une densité de dislocation de 10⁷cm⁻² ou inférieure.

5. Procédé de fabrication selon l'une des revendications précédentes, dans lequel l'angle de troncature (a1) non nul au voisinage du centre de la face avant est compris entre 0,1 et 5 degrés, préférentiellement compris entre 0,2 et 0,8 degrés, encore plus préférentiellement compris entre 0,3 et 0,6 degrés, les plans de coupe (P) s'étendant perpendiculairement à l'axe principal (7) du cristal (5).

6. Procédé de fabrication selon l'une quelconque des revendications précédentes, dans lequel les plans de coupe (P) s'étendent :
- perpendiculairement à l'axe principal (7) du cristal (5), et
- parallèlement les uns aux autres le long dudit axe principal (7),
de sorte à obtenir des plaquettes de nitrure d'élément 13 (5a, 5b, 5c, 5d) d'épaisseur comprise entre 300 micromètres et 1 millimètre.

7. Procédé de fabrication selon l'une des revendications précédentes, dans lequel la phase de formation (20) d'une zone de séparation (4) comprend le dépôt d'une couche de silicium sur le substrat de départ (1), ladite couche de silicium étant destinée à être vaporisée spontanément durant la phase de reprise d'épitaxie (30).

8. Procédé de fabrication selon l'une des revendications 1 à 6, dans lequel la phase de formation (20) d'une zone de séparation (4) comprend une étape d"implantation d'ions, ladite étape d'implantation étant mise en œuvre pendant ou après la phase de croissance épitaxiale (10) de la première couche (5') de nitrure d'élément 13.

9. Procédé de fabrication selon l'une quelconque des revendications précédentes, dans lequel la phase de croissance épitaxiale (10) de la première couche (5') de nitrure d'élément 13 est une phase de surcroissance latérale épitaxiale (ELO) ou universelle (ULO) de la première couche de nitrure d'élément 13.

10. Procédé de fabrication selon la revendication 9, dans lequel la phase de croissance épitaxiale (10) de la première couche de nitrure d'élément 13 comprend :
- une étape de dépôt d'un masque incluant des ouvertures (3a),
- une étape de croissance d'ilots de nitrure d'élément 13 à travers les ouvertures (3a), les ilots présentant un plan de cristallisation compris entre 0,1 et 5 degrés, préférentiellement compris entre 0,2 et 0,8 degrés, et encore plus préférentiellement compris entre 0,3 et 0,6 degrés,
- une étape de croissance latérale pour favoriser la coalescence des îlots afin d'obtenir la première couche de nitrure d'élément 13 (5').

11. Procédé de fabrication selon l'une quelconque des revendications précédentes, dans lequel la phase de croissance épitaxiale (10) de la première couche (5') de nitrure d'élément 13 comprend une étape de dépôt d'une couche tampon (2) de nitrure d'élément 13 entre le substrat de départ (1) et ladite première couche (5') de nitrure d'élément 13, à une température comprise entre 500 et 700°C, la couche tampon (2) étant choisie parmi l'AIN ou l'AlGaN.

12. Procédé de fabrication selon la revendication 11, dans lequel la phase de croissance épitaxiale (10) de la première couche (5') de nitrure d'élément 13 comprend une étape de recuit de la couche tampon (2) à une température comprise entre 900 et 1150°C, de sorte à convertir la couche tampon (2) initialement continue en une couche discontinue de motifs de nitrure d'élément 13.

## Patentansprüche

1. Verfahren zur Herstellung von Element 13-Nitrid-Wafern (5a, 5b, 5c, 5d), wobei jeder Wafer (5a, 5b, 5c, 5d) eine Vorderseite (54) und eine Hauptachse (7) umfasst, die orthogonal zu seiner Vorderseite (54) ist und durch das Zentrum dieser Vorderseite (54) verläuft, wobei diese Vorderseite (54) einen Trunkierungswinkel (α1) ungleich null in der Nähe ihres Zentrums und Trunkierungswinkelwerte hat, die symmetrisch um ihre Hauptachse (7) in einer Symmetrieebene verteilt sind, die die Hauptachse (7) des Wafers enthält und eine Achse C, die zu einer Kristallausrichtungsebene C orthogonal ist und diese Trunkierungswinkelwerte in Richtung der Peripherie des Wafers entlang der Symmetrieebene abnehmen, wenn die seiner Vorderseite (54) gegenüberliegende Oberfläche konkav ist, und in Richtung der Peripherie des Wafers entlang der Symmetrieebene zunehmen, wenn die seiner Vorderseite (54) gegenüberliegende Oberfläche konvex ist, wobei dieses Verfahren umfasst:
- eine epitaxiale Wachstumsphase (10) einer ersten Element 13-Nitrid-Waferschicht (5') auf einem Ausgangssubstrat (1), das einen Trunkierungswinkel aufweist, der zwischen 0,1 und 5 Grad, vorzugsweise zwischen 0,2 und 0,8 Grad und noch vorzugsweiser zwischen 0,3 und 0,6 Grad liegt,
- eine Phase der Bildung (20) einer Trennzone (4) ;
- eine Epitaxiwiederaufnahmephase (30), um eine zweite Element 13-Nitrid-Waferschicht (5") auf der ersten Element 13-Nitrid-Waferschicht (5') zu bilden, wobei diese Epitaxiwiederaufnahmephase (30) nach Abschluss der epitaxialen Wachstumsphase (10) und der Phase der Bildung (20) der Trennzone (4) durchgeführt wird,
- eine Spontantrennungsphase (40) im Bereich der Trennzone (4) während der Epitaxiwiederaufnahmephase (30), um einen gewölbten selbstragenden Element 13-Nitridkristall (5) zu erhalten, der sich längs einer Hauptachse (7) orthogonal zu einer Wachstumsfläche (52) des Kristalls (5) erstreckt und durch das Zentrum (53) der Wachstumsfläche verläuft, wobei der gewölbte selbsttragende Kristall (5) einen Trunkierungswinkelwert ungleich null und einen Krümmungsradius unter 25 Meter aufweist,
- eine Phase des Schneidens (50) des gewölbten selbsttragenden Kristalls (5) gemäß zum Kristall transversalen und zur Hauptachse (7 - A-A') des Kristalls (5) senkrechten Schnittebenen (P), derart, dass die Element 13-Nitrid-Wafer (5a, 5b, 5c, 5d) erhalten werden, wobei die Phase des Bildens (20) der Trennzone (4) vor, nach oder während der epitaxialen Wachstumsphase (10) durchgeführt wird.

2. Herstellungsverfahren nach Anspruch 1, wobei der gewölbte selbsttragende Kristall (5) einen Krümmungsradius unter 20 Meter aufweist.

3. Herstellungsverfahren nach einem der Ansprüche 1 oder 2, wobei der Krümmungsradius 5 Meter oder mehr beträgt.

4. Herstellungsverfahren nach einem der vorangehenden Ansprüche, wobei der gewölbte selbsttragende Kristall (5) eine Dislokationsdichte von 10⁷ cm⁻² oder weniger hat.

5. Herstellungsverfahren nach einem der vorangehenden Ansprüche, wobei der Trunkierungswinkel (α1) ungleich null in der Nähe des Zentrums der Vorderseite zwischen 0,1 und 5 Grad, vorzugsweise zwischen 0,2 und 0,8 Grad, noch vorzugsweiser zwischen 0,3 und 0,6 Grad liegt, wobei sich die Schnittebenen (P) senkrecht zur Hauptachse (7) des Kristalls (5) erstrecken.

6. Herstellungsverfahren nach einem der vorangehenden Ansprüche, wobei sich die Schnittebenen (P) erstrecken:
- senkrecht zur Hauptachse (7) des Kristalls (5), und
- parallel zueinander entlang der Hauptachse (7), derart, dass Element 13-Nitrid-Wafer (5a, 5b, 5c, 5d) mit einer Dicke erhalten werden, die zwischen 300 Mikrometer und 1 Millimeter liegt.

7. Herstellungsverfahren nach einem der vorangehenden Ansprüche, wobei die Phase des Bildens (20) einer Trennzone (4) das Aufbringen einer Siliziumschicht auf das Ausgangssubstrat (1) umfasst, wobei die Siliziumschicht bestimmt ist, während der Epitaxiwiederaufnahmephase (30) spontan verdampft zu werden.

8. Herstellungsverfahren nach einem der Ansprüche 1 bis 6, wobei die Phase des Bildens (20) einer Trennzone (4) einen Ionenimplantationsschritt umfasst, wobei der Implantationsschritt während oder nach der epitaxialen Wachstumsphase (10) der ersten Element 13-Nitridschicht (5') durchgeführt wird.

9. Herstellungsverfahren nach einem der vorangehenden Ansprüche, wobei die epitaxiale Wachstumsphase (10) der ersten Element 13-Nitridschicht (5') eine epitaxiale Seiten- (ELO) oder Universal- (ULO) Überwachstumsphase der ersten Element 13-Nitridschicht ist.

10. Herstellungsverfahren nach Anspruch 9, wobei die epitaxiale Wachstumsphase (10) der ersten Element 13-Nitridschicht umfasst:
- einen Schritt des Aufbringens einer Maske, die Öffnungen (3a) einschließt,
- einen Schritt des Wachstums von Element 13-Nitridinseln durch die Öffnungen (3a), wobei die Inseln eine Kristallisationsebene zwischen 0,1 und 5 Grad, vorzugsweise zwischen 0,2 und 0,8 Grad und noch vorzugsweiser zwischen 0,3 und 0,6 Grad aufweisen,
- einen Seitenwachstumsschritt, um die Koaleszenz der Inseln zu fördern, um die erste Element 13-Nitridschicht (5') zu erhalten.

11. Herstellungsverfahren nach einem der vorangehenden Ansprüche, wobei die epitaxiale Wachstumsphase (10) der ersten Element 13-Nitridschicht (5') einen Schritt des Aufbringens einer Element 13-Nitridpufferschicht (2) zwischen dem Ausgangssubstrat (1) und der ersten Element 13-Nitridschicht (5') bei einer Temperatur zwischen 500 und 700 °C umfasst, wobei die Pufferschicht (2) aus AIN oder AIGaN ausgewählt ist.

12. Herstellungsverfahren nach Anspruch 11, wobei die epitaxiale Wachstumsphase (10) der ersten Element 13-Nitridschicht (5') einen Härteschritt der Pufferschicht (2) bei einer Temperatur zwischen 900 und 1150 °C umfasst, derart, dass die anfänglich kontinuierliche Pufferschicht (2) in eine diskontinuierliche Element 13-Nitridmotivschicht umgewandelt wird.

## Claims

1. A method of manufacturing 13-nitride wafers (5a, 5b, 5c, 5d), each wafer (5a, 5b, 5c, 5d) comprising a front face (54) and a major axis (7) orthogonal to its front face (54) and passing through the center of that front face (54) said front face (54) having a non-zero truncation angle (α1) in the vicinity of its center and truncation angle values symmetrically distributed about its major axis (7) in a plane of symmetry containing said major axis (7) of the wafer and a C-axis which is orthogonal to a C-orientated crystal plane and said truncation angle values decreasing toward the periphery of the wafer along said plane of symmetry when the surface opposite its front face (54) is concave, and increasing toward the periphery of the wafer, along said plane of symmetry when the surface opposite its front face (54) is convex , which method comprises
- an epitaxial growth phase (10) of a first layer (5') of element 13 nitride on a starting substrate (1) having a truncation angle of between 0.1 and 5 degrees, preferably between 0.2 and 0.8 degrees, and even more preferably between 0.3 and 0.6 degrees
- a formation phase (20) of a separation zone (4);
- an epitaxy recovery phase (30), to form a second layer (5") of elemental nitride 13 on said first layer (5') of elemental nitride 13, this epitaxy recovery phase (30) being carried out at the end of the epitaxial growth phase (10) and of the separation zone (4) formation phase (20)
a spontaneous separation phase (40) , in the separation zone (4), during the epitaxy recovery phase (30) , to obtain a domed self-supported crystal (5) of element 13 nitride extending longitudinally along a principal axis (7) orthogonal to a growth face (52) of said crystal (5) and passing through the center (53) of said growth face said domed self-supported crystal (5) having a non-zero truncation angle and a radius of curvature of less than 25 meters,
a cutting phase (50) of said curved self-supported crystal (5), according to cutting planes (P) transverse to the crystal and perpendicular to the main axis (7 - A-A') of the crystal (5), so as to obtain said platelets (5a, 5b, 5c, 5d) of element 13 nitride, the phase of formation (20) of the separation zone (4) being implemented before, after or during the epitaxial growth phase (10)

2. The manufacturing process according to claim 1, wherein the self-supporting domed crystal (5) has a radius of curvature of less than 20 meters

3. The manufacturing method of any of claims 1 or 2 wherein the radius of curvature is 5 meters or more.

4. The manufacturing method according to any of the preceding claims, wherein the domed self-supported crystal (5) has a dislocation density of 10⁷ cm⁻² or less.

5. A manufacturing method according to any of the preceding claims, wherein the non-zero truncation angle (α1) in the vicinity of the center of the front face is between 0.1 and 5 degrees, preferably between 0.2 and 0.8 degrees, even more preferably between 0.3 and 0.6 degrees, the cutting planes (P) extending perpendicular to the main axis (7) of the crystal (5).

6. A manufacturing method according to any of the preceding claims, wherein the cutting planes (P) extend :
- perpendicular to the main axis (7) of the crystal (5), and
- parallel to each other along said main axis (7),
so as to obtain element 13 nitride platelets (5a, 5b, 5c, 5d) with a thickness of between 300 micrometers and 1 millimeter.

7. A manufacturing method according to one of the preceding claims, wherein the formation phase (20) of a separation zone (4) comprises the deposition of a silicon layer on the starting substrate (1), said silicon layer being intended to be spontaneously vaporized during the epitaxy recovery phase (30).

8. A manufacturing method according to any of claims 1 to 6, wherein the formation step (20) of a separation zone (4) comprises an ion implantation step, said implantation step being implemented during or after the epitaxial growth phase (10) of the first layer (5') of element 13 nitride.

9. The manufacturing method according to any one of the preceding claims, wherein the epitaxial growth phase (10) of the first element nitride 13 layer (5') is an epitaxial lateral overgrowth (ELO) or universal overgrowth (ULO) phase of the first element nitride 13 layer.

10. The manufacturing method of claim 9, wherein the epitaxial growth phase (10) of the first element nitride layer 13 comprises:
- a step of depositing a mask including openings (3a),
- a step of growing islands of elemental nitride 13 through the openings (3a), the islands having a crystallization plane of between 0.1 and 5 degrees, preferably between 0.2 and 0.8 degrees, and even more preferably between 0.3 and 0.6 degrees,
- a lateral growth step to promote the coalescence of the islands in order to obtain the first layer of element 13 nitride (5').

11. A manufacturing method according to any one of the preceding claims, wherein the epitaxial growth phase (10) of the first layer (5') of element 13 nitride comprises a step of depositing a buffer layer (2) of element 13 nitride between the starting substrate (1) and said first layer (5') of element 13 nitride , at a temperature of between 500 and 700°C, the buffer layer (2) being selected from AIN or AIGaN.

12. The manufacturing method according to claim 11, wherein the epitaxial growth phase (10) of the first layer (5') of element 13 nitride comprises a step of annealing the buffer layer (2) at a temperature between 900 and 1150°C, so as to convert the initially continuous buffer layer (2) into a discontinuous layer of element 13 nitride patterns.
